# EUROPEAN PATENT SPECIFICATION

(11) **EP 0 433 468 B1**
(45) Date of publication and mention of the grant of the patent: **30.11.1994**
(21) Application number: 89123358.7
(22) Date of filing: 18.12.1989
(51) Int. Cl.: H03F 3/08, H04B 10/14

(54) **Current voltage converter**
Strom-Spannungswandler
Convertisseur de courant en tension

(43) Date of publication of application: 26.06.1991
(73) Proprietor: Hewlett-Packard GmbH, D-71004 Böblingen (DE)
(72) Inventor: Gross, Siegfried, D-7262 Neuhengstett (DE); Fleischer-Reumann, Michael, D-7268 Gechingen (DE)
(74) Representative: Harbach, Thomas

(56) References cited:
- EP-A- 0 185 199
- DE-A- 3 543 677
- GB-A- 2 194 406
- US-A- 3 968 361
- US-A- 4 578 576
- PATENT ABSTRACTS OF JAPAN vol. 11, no. 83 (E-489)(2530) 13 March 1987,& JP-A-61 237534
- PATENT ABSTRACTS OF JAPAN vol. 3, no. 89 (E-126) 28 July 1979,& JP-A-54 66836

## Description

The invention relates to a current voltage converter comprising :
an input terminal, amplifier means comprising an inverting amplifier having an inverting input terminal and an output terminal, the output terminal being coupled to the input terminal of the current voltage converter via a resistor, wherein one end of a voltage clipping means is connected with the input terminal of the current voltage converter, and wherein the inverting amplifier has a gain such that the maximum of the output voltage of a specific polarity of the inverting amplifier is the product of the gain between the input terminal of the current voltage converter and the output terminal of the inverting amplifier by the corresponding maximum voltage across the clipping means.

In optical time-domain reflectometers (OTDRs) used for example for testing glass fibers an optical receiver is used having an avalanche photodiode or a PIN diode as receiving element for an optical signal and a transimpedance amplifier which converts the photocurrent delivered by the receiving diode into a voltage. The principle of such a circuit is described in Hewlett-Packard Journal, December 1988, pages 26 to 28.

An important problem of such circuits is the behavior on overloading by a very great optical pulse. In case of a conversion factor between optical input power and output voltage of 1000 V/mW, as is usual for transimpedance amplifiers in the measurement technology, and further assuming a supply voltage of 12 V, the saturation is reached at an optical power of as low as 12 µW. (A transimpedance amplifier is provided with a negative feedback.)

After overloading such amplifiers have (for use in optical receivers) very long relaxation times (up to 10 µs) until the operating point is exactly readjusted. This behavior is especially disadvantageous when measuring optical backscatter since very low signal levels (about 1 nW) have to be measured and at the same time it is possible that very great optical pulses (up to 1 mW) occur resulting from reflections at plugs. It is intended that in optical time-domain reflectometers the transient time for reaching a value of as low as about 0.01 o/oo deviation from operating point after a high reflection pulse is not greater than 30 ns. This is not possible with known transimpedance amplifiers.

From DE-A-3 543 677 a current voltage converter of the above mentioned type is known. This prior art discloses an optical receiver comprising a photodiode and a transimpedance amplifier which has an additional circuit comprising a non-linear two-terminal circuitry, for example a diode, with small capacitance, and which conducts the direct current of the photodiode through the two-terminal circuitry at an increasing rate when the direct current increases, and thus reduces its differential resistance so that, at high levels of the optical input signal, the alternating output voltage of the optical receiver increases only insubstantially with increasing alternating photo current.

The present invention shows a possibility to provide a transimpedance amplifier or more generally a current voltage converter with a better behavior on overloading without changing the bandwidth and other essential parameters of the amplifier.
Therefore, it is an object of the invention, to reduce the influence of overloading on current voltage converters.

The invention is characterized in that a second amplifier is inserted into the path from the input terminal of the current voltage converter to the inverting input terminal of the inverting amplifier, a third amplifier is provided, the input terminal of which is coupled to the output terminal of the second amplifier, and the output terminal of the third amplifier is coupled to the other end of the clipping means, that the product of the gains of the second and third amplifiers is approximately +1, but not greater than +1, and that the output voltage swing of the third amplifier is limited without saturation of the third amplifier.

If the second amplifier has a gain of about + 1 as provided in an embodiment of the invention, the second amplifier does not affect the function of the inverting amplifier. If the gain is different from +1, it is necessary to change the gain of the inverting amplifier in order to get the same overall gain as discussed above.

The clipping means can easily be realized by at least one diode providing a threshold voltage, preferably a Schottky diode having a barrier voltage or threshold of about 0.4 V in the flow direction.

For small input signals (input currents) because of the positive feedback provided by the second and third amplifiers the effect of a parasitic capacitance of the clipping means (e.g. the parasitic capacitance of the mentioned Schottky diode) connected to the input terminal of the current voltage converter is totally or almost totally compensated, since the output voltage of the third amplifier has almost the same value and phase as the input voltage of the current voltage converter and, therefore, almost or absolutely no current is flowing through the capacitance. Thus, a great bandwidth exists for small input signals.

After the input current has raised to such a value that the output voltage of the third amplifier is limited and, therefore, does no more follow the input voltage of the current voltage converter, on further rise of the input current a voltage appears across the clipping means. When this voltage reaches the barrier voltage or threshold voltage of the clipping means the input voltage of the current voltage converter is limited without saturation of any of the amplifiers.

The mentioned limitation of the third amplifier can easily realized by a further clipping means (preferably at least one diode) connected between a fixed potential, e.g. ground, and that end of the clipping means which is not connected with the input terminal of the current voltage converter.

Further embodiments of the invention provide simple circuits for performing the invention.

Further features and advantages of the invention will become apparent from the following description of specimen embodiments of the invention with reference to the drawings showing essential details of the invention, and from the claims. The individual features may be realized individually or in any desired combination in an embodiment of the invention.
- Fig. 1: shows the schematic circuit of a first example of a transimpedance amplifier according to the invention,
- Fig. 2: shows the idealized characteristic of an amplifier circuit of the state of the art,
- Fig. 3: shows a second example of a transimpedance amplifier according to the invention,
- Fig. 4: shows a third example of a transimpedance amplifier according to the invention,
- Fig. 5: shows the behavior of the circuit of Fig. 4,
- Fig. 6: shows one realized circuit according to the principle of Fig. 5, and
- Fig. 7: shows a constant current circuit usable in the circuit of Fig. 6.

Through the invention is discussed with special reference to transimpedance amplifiers for OTDRs, it will be apparent for the expert that the invention is also usable for other kinds of current voltage converters. The invention is usable for input signals having a high frequency as well as for low frequency input signals and for D.C. input signals.

In the figures, clipping or limitation of the input voltage Ui is shown only for one polarity. It is possible to provide clipping for two polarities by providing clipping means which also clip the other polarity. This can be realized easily by the use of Schottky diodes, since Schottky diodes are used in the flow direction and are blocked in the reverse direction (in contrast to for example Z-diodes which are used in the reverse direction). Also the below mentioned amplifiers U1, U2 and U3 have to be able to function for the two polarities of input signals.

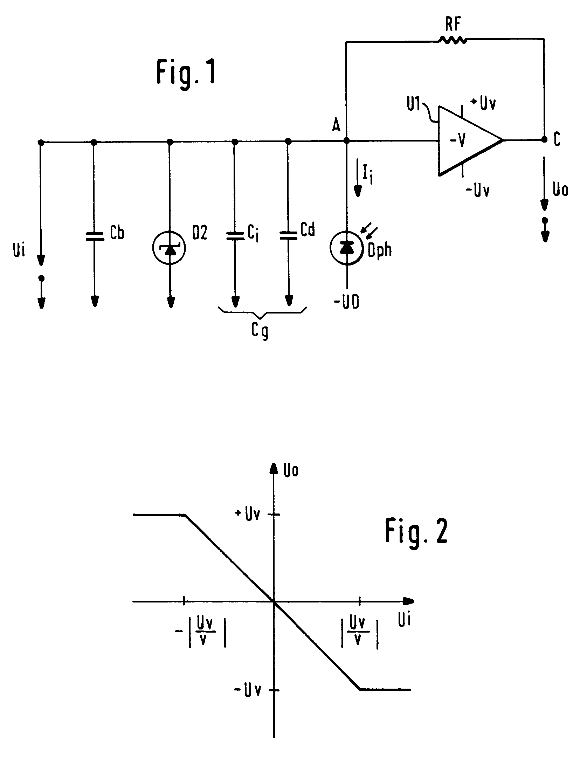

The transimpedance amplifier shown in Fig. 1 differs from known transimpedance amplifiers only in that it comprises a clipping means provided by a diode D2 having a parasitic capacitance represented by capacitor Cb, and in that the absolute value of the gain of the inventive amplifier is much smaller than that of the known amplifier. In the following the known amplifier will be discussed. In the known transimpedance amplifier the inverting amplifier U1 has a great voltage gain of -v. The inverting amplifier U1 is supplied with supply voltages +Uv and -Uv. Between its output terminal C and the input terminal A of the transimpedance amplifier or current voltage converter a resistor RF performing a negative feedback is inserted. Current iᵢ to be converted into the output voltage Uo is provided by a photodiode Dph, the cathode of which is connected to the terminal A and the anode of which is connected to a negative supply voltage -U_{D}. The input capacitance of the inverting amplifier is symbolized by a capacitor Ci, and the capacitance of the photodiode is symbolized by a capacitor Cd the sum of which is the value Cg. As known, the transfer function of the circuit of Fig. 1 is$\frac{{\text{U}}_{\text{o}}}{{\text{I}}_{\text{i}}} \text{=} \frac{\text{v}}{\text{v+1}} {\text{· R}}_{\text{F}} \frac{\text{1}}{\text{1+sτ}}$
where$\text{τ =} \frac{{\text{R}}_{\text{F}} {\text{C}}_{\text{g}}}{\text{V + 1}}$
and s is the complex angular frequency.

The photodiode Dph behaves approximately as a current source the current of which depends on the received light.

If the inverting amplifier is saturated by a great input current from the photodiode Dph, the capacitance Cg is discharged with a time constant${\text{τ′= R}}_{\text{F}} {\text{C}}_{\text{g}}$

Only after discharge of the capacitance Cg the amplifier is able to work linearly. Further, all inverting amplifiers available at present have a very great transient time when brought into saturation due to the resulting thermal unbalance if very small deviations from the operating point are required. These facts make it necessary that a saturation of the amplifier is absolutely avoided.

In the inventive transimpedance amplifier shown in Fig. 1, this is achieved by the diode D2 and the choice of the absolute value of the gain such that the following equation is valid:$\text{| -v | =} \frac{{\text{U}}_{\text{o max}}}{{\text{U}}_{\text{c}}}$
Uo max is that maximum output voltage, at which the inverting amplifier is not yet saturated. This output voltage depends on the supply voltages +Uv and -Uv and its absolute value is necessarily smaller than the mentioned supply voltages. Uc is the threshold or barrier voltage of diode D2.

In the circuit of Fig. 1, because of the relatively low gain of the inverting amplifier U1, the input voltage Ui is not held near zero as in known amplifiers, but can reach the barrier voltage or threshold voltage of the diode D2, which may be 0.4 V, and, therefore, this diode can function as a clipping means for the current voltage converter. Fig. 1 functions well for low frequencies since at low frequencies the capacitor Cb does not contribute remarkably to a reduction of the bandwidth of the current voltage converter.

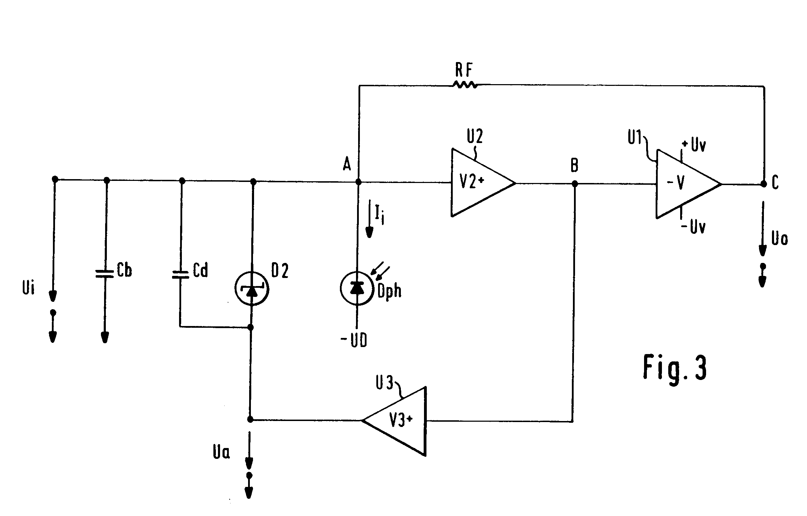

In the embodiment shown in Fig. 3, the lower end of diode D2 is not connected to ground as in Fig. 1. Between the connecting point of the photodiode Dph and the diode D2 which is the terminal A also in this embodiment, and the inverting input terminal of the inverting amplifier U1, a second amplifier U2 is connected which has a positive gain V2+. The output terminal of the second amplifier U2 is connected to the input terminal of a third amplifier U3 having a positive gain V3+. The output terminal of the third amplifier is connected to the lower end of the diode D2.

The gains of the second and third amplifiers U2 and U3, respectively, are chosen such that their product is at least approximately +1, but not greater than +1 in order to avoid instabilities. Preferably, the gain of each amplifier U2 and U3 is +1. Thus, the voltage occurring at the terminal A appears also with the same value and phase at the point D, namely the output terminal of the third amplifier U3. Therefore, there is no voltage across the diode D2 and its associated capacitor Cb and any current cannot flow through the capacitor. This is valid as long as the voltage Ua at the point D follows exactly the voltage Ui at the terminal A. The third amplifier U3 is provided with a limitation of its output voltage without saturation of amplifier U3.

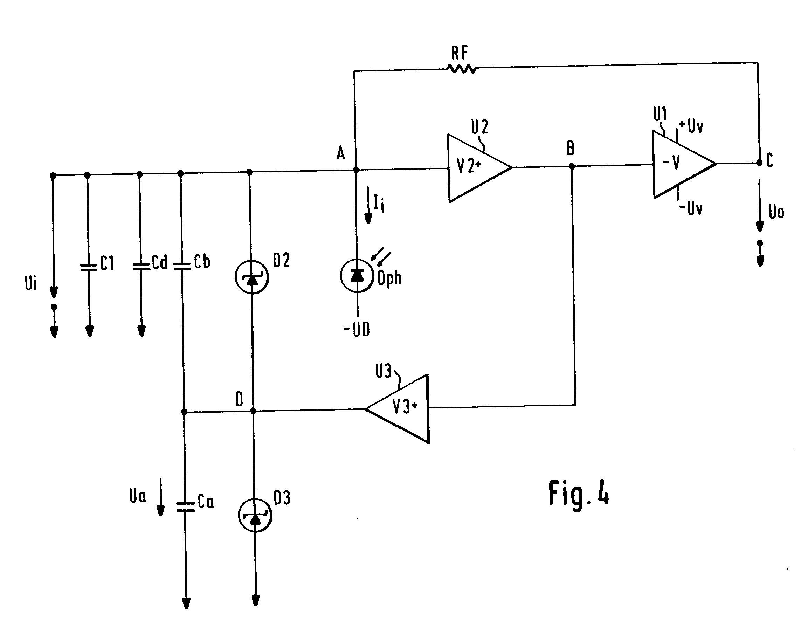

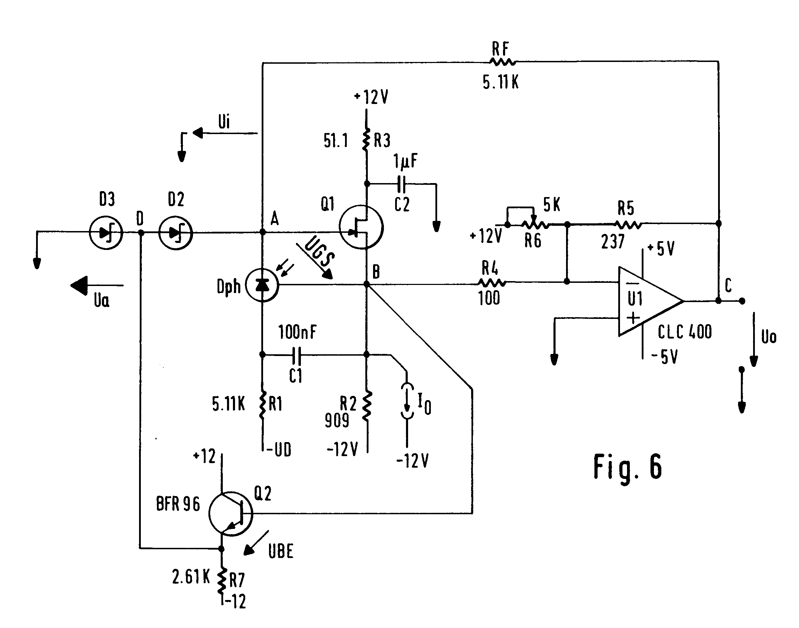

According to the example shown in Fig. 4, this limitation is realized by a diode D3 connected between the output terminal of the third amplifier U3 and ground. Also diode D3 has a parasitic capacitance corresponding to the capacitor Ca. Therefore, the output terminal of the third amplifier U3 in Fig. 4 is also connected to the connecting point of the capacitors Cb and Ca.

As long as the voltage Ui at the input terminal A of the current voltage converter and therefore the voltage Ua at the point D is smaller than the threshold provided by the third amplifier U3 Fig. 3) or the diode D3 Fig. 4), the voltage Ua can vary corresponding to the voltage Ui.

Thus, for small input signals (small currents iᵢ) and resulting small voltages Ui the bandwidth is relatively high since the capacitance Cb of the diode D2 does not have any effect on the bandwidth.

In the following, the circuit of Fig. 4 is described. When the current iᵢ becomes greater and, therefore, the voltage Ui at the terminal A becomes more negative, the voltage Ua is kept approximately constant since the diode D3 is chosen such that it provides an approximately constant voltage across it when current flows through said diode D3. Now with the just mentioned greater signal iᵢ at the terminal A, a voltage different from zero lies across the diode D2 and its associated capacitance Cb. Therefore, the capacitance Cb reduces the bandwidth of the current voltage converter.

When the current iᵢ and accordingly the voltage Ui becomes greater, the threshold of the diode D2 is finally reached with the result that further increase of the current iᵢ does not produce a further increase of the voltage Ui and, therefore, the output voltage Uo does not increase. In this moment the overall current voltage converter has a dynamic gain of zero. Nevertheless, none of the amplifiers U1, U2, U3 is saturated. Thus, as soon as the current iᵢ becomes smaller such that the threshold of the diode D2 is no more reached, the current voltage converter immediately works correctly again.

The function described above of the circuit according to Fig. 4 makes it necessary to adjust the gain of the inverting amplifier U1 and the dependence of the voltage Ui on the current iᵢ such that the two diodes D2, D3 are fully conductive before the inverting amplifier U1 begins to saturate. Assuming that the diodes D2, D3 are identical, this can be expressed by the following equation:$\text{-v <} \frac{{\text{U}}_{\text{o max}}}{{\text{2 · U}}_{\text{c}}}$

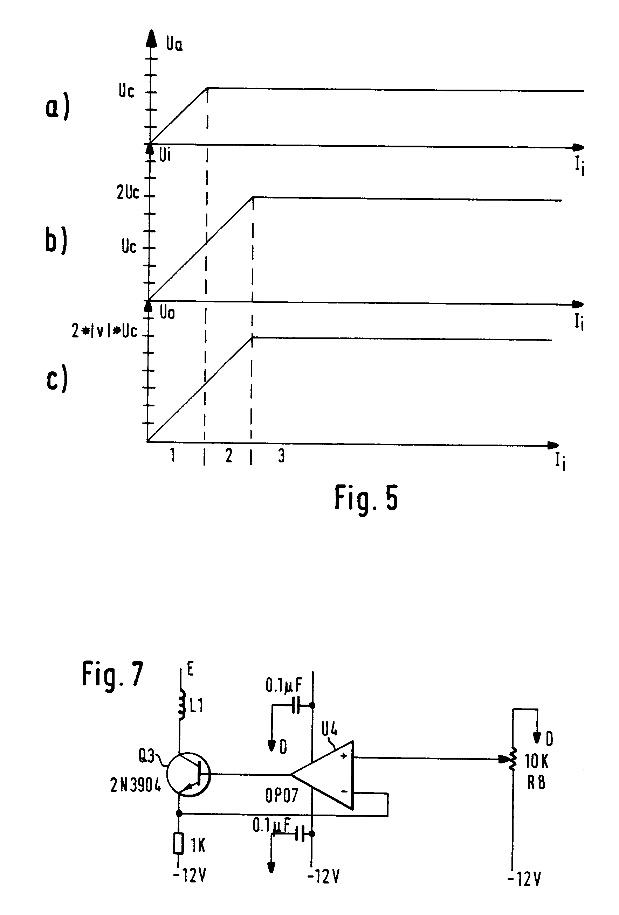

Fig. 5a to c shows the dependencies of Ua on iᵢ, Ui on iᵢ, and Uo on iᵢ, respectively. There can be seen three different zones:
Zone 1: Linear function at high bandwidth
Zone 2: Area of transition into limitation (with reduced bandwidth),
Zone 3: Zone of limitation (amplifiers U1, U2, U3 working linearly).

Fig. 6 shows a realized circuit. The inverting amplifier U1 is realized in the embodiment by an integrated circuit CLC400. The non-inverting input of the inverting amplifier U1 is connected to ground. The amplifier U2 of Fig. 4 is realized by a field effect transistor (FET) Q1, the gate terminal of which is connected to the point A, the source terminal of which is connected to a point B and the drain of which is connected via a resistor R3 to a positive supply voltage. The point B is connected via a resistor R4 to the inverting input of the inverting amplifier U1.

The transistor Q1 in the embodiment is a GaAs field effect transistor for small signals having very small capacitances between gate and drain on the one side and gate and source on the other side. (Cgs = 0.2 pF; Cgd = 0.08 pF). At the same time, this transistor has a very great impedance at its gate which fact is essential when very small signal currents iᵢ have to be processed.

The inverting input of the inverting amplifier U1 is connected via a resistor R5 to the output of the inverting amplifier, and via an adjustable resistor R6 to a positive supply voltage. This makes it possible to compensate the D.C. offset between gate and source of Q1, such that for an input voltage Ui of 0 V the output voltage Uo is 0 V.

The amplifier U3 of Fig. 3 is realized in Fig. 6 by an emitter follower comprising a NPN transistor Q2, the emitter of which is connected via a resistor R7 to a negative supply voltage and the collector of which is connected to a positive supply voltage. The emitter is connected to the connection point D between the two diodes D2 and D3. This circuit is very simple and automatically provides for a current limitation which is necessary in order to avoid the destruction of the diode D3 and/or the third amplifier U3. When the base potential of Q2 is lowered because of the occurrence of an optical signal at the photodiode Dph, then the emitter voltage follows the base potential as long as the diode D3 is not conductive. When the emitter potential is so low that at the diode D3 the threshold voltage Uc occurs, this diode becomes conductive and prevents further lowering of the emitter potential of Q2. When due to a greater current iᵢ through the photodiode Dph the base potential of Q2 is controlled more to negative values then the base emitter voltage of Q2 is reduced and thus the current through transistor Q2 is reduced, too. In this case the current through the diode D3 raises, however is limited by the resistor R7. The further advantage of this circuit is that the transistor Q2 never is switched off totally, since the emitter voltage of Q2 does never reach a potential lower than -Uc, and since the voltage Ui does never become more negative than -2xUc.

If, as preferred, the diodes D2, D3 are Schottky diodes having Uc = 0.4 V, then the minimum Ube of Q2 is 0.4 V. Thus, transistor Q2 is not blocked totally. If Q2 was switched off totally this fact would have a negative influence on the dynamic behavior of the circuit.

The D.C. voltage offset Ugso between the gate and the source of the FET Q1 is adjusted by means of an adjustable constant current circuit (so-called current source) Iq such that the following equation is valid:${\text{| U}}_{\text{gso}} {\text{| = U}}_{\text{BE0}}$

With this setting, Ua is 0 V and the voltage drop across the diode D2 is also 0 V.

The effects of the parasitic capacitances of the photodiode Dph are eliminated by means of a capacitor C1 connected between the anode of the photodiode and the point B. Thus, the circuit shown in Fig. 6 has good limiting properties and a bandwidth for small signals of 100 MHz.

The current source Iq may be realized in some cases by a resistor. However, the circuit shown in Fig. 7 may be used in all cases. A NPN transistor Q3 and an operational amplifier U4 are connected in the manner shown in Fig. 7. E is the output terminal of the constant current source or device and is to be connected with point B in Fig. 6. A bead at the collector of Q3 provides an inductor L1 preventing oscillations. R8 is a potentiometer for setting the output current. In the example, Q3 is of the type 2N3904 and U4 is of the type OP07.

In Fig. 6 the values of the different resistors, capacitors and so on are inserted. The value of for example "237" for R5 means 237 ohms. A value of for example 5.11 K means 5.11 kiloohms. The supply voltages of the circuit of Fig. 6 are, as inserted in the drawing, +5 V,-5 V, +12 V and -12 V. The photodiode Dph in the example has a metallic housing which is connected with the point B in order to reduce the influence of parasitic capacitances.

In the example of Fig. 6, the transistor Q1 is of the type MGF 1302, transistor Q2 is of the type BFR 96, the diodes D2, D3 are Schottky diodes of the type HP 2811 and the photodiode Dph has a responsivity of 15 A/W at about 1300 nm and is provided with a voltage -U_{D} of about 80 V and thus much smaller than voltage Ui. The gain of the amplifier U1 is given by the resistors R5 and R4 and is about 2.34. The gains of the other amplifiers are +1 each. The maximum input voltage at the point A is -0.8 V, the maximum output voltage at point C is 1.872 V.

The Schottky diodes are connected in flow direction in order to use their threshold of 0.4 V in flow direction. Schottky diodes are very quick and have small parasitic capacitances. In other cases it might be advisable to use for example Z diodes (e.g. Zener diodes) and connect them in reverse direction as usual for those diodes.

The reference numerals in the claims are not a limitation but shall facilitate understanding.

## Claims

1. Current/voltage converter comprising: an input terminal (A), amplifier means comprising an inverting amplifier (U1) having an inverting input terminal and an output terminal, the output terminal being coupled to the input terminal (A) of the current/voltage converter via a resistor (RF),
wherein one end of a voltage clipping means is connected with the input terminal (A) of the current/voltage converter, and wherein the inverting amplifier (U1) has a gain such that the maximum of the output voltage (Uo) of a specific polarity of the inverting amplifier (U1) is the product of the voltage-gain between the input terminal (A) of the current/voltage converter and the output terminal (C) of the inverting amplifier (U1) by the corresponding maximum voltage across the clipping means,
**characterized** in that
a second amplifier (U2) is inserted into the path from the input terminal (A) of the current/voltage converter to the inverting input terminal of the inverting amplifier (U1),
a third amplifier (U3) is provided, the input terminal of which is coupled to the output terminal of the second amplifier (U2), and the output terminal of the third amplifier (U3) is coupled to the other end of the clipping means, that the product of the gains of the second and third amplifiers is approximately +1, but not greater than +1, and that the output voltage swing of the third amplifier (U3) is limited without saturation of the third amplifier.

2. Current\voltage converter as claimed in claim 1, characterized in that the gains of the second amplifier (U2) and third amplifier (U3) are approximately +1.

3. Current\voltage converter as claimed in claim 1 or 2, characterized in that the limitation of the output voltage swing of the third amplifier (U3) is realized by a further clipping means connected between the output terminal of the third amplifier and a fixed potential.

4. Current\voltage converter as claimed in claim 3, characterized in that the third amplifier (U3) comprises a transistor (Q2) the base of which is coupled to the output of the second amplifier (U2), the emitter of which is connected to the connecting point (D) of the clipping means and the further clipping means and is connected via a resistor (R7) to a voltage level different from ground.

5. Current\voltage converter as claimed in any of the claims 2 - 4, characterized in that the second amplifier comprises a FET, the gate of which is connected to the input terminal (A) of the current\voltage converter and the source of which is the output terminal of the second amplifier.

6. Current\voltage converter as claimed in any of the claims 2 - 5, characterized in that the output terminal of the second amplifier is connected to a constant current device (IQ).

7. Current\voltage converter as claimed in any of the preceding claims, characterized in that its input terminal (A) is connected to a photoelectric receiving element, preferably a photodiode (Dph).

## Patentansprüche

1. Strom-Spannungswandler mit einem Eingangsanschluß (A), Verstärkermitteln, die einen invertierenden Verstärker (U1) enthalten, der einem invertierenden Eingangsanschluß und einem Ausgangsanschluß besitzt, wobei der Ausgangsanschluß mit dem Eingangsanschluß (A) des Strom-Spannungswandlers über einen Widerstand (RF) verbunden ist,
wobei ein Ende eines Spannungsbegrenzungsmittels mit dem Eingangsanschluß (A) des Strom-Spannungswandlers verbunden ist und wobei der invertierende Verstärkers (U1) einen Verstärkungsfaktor derart besitzt, daß die maximale Ausgangsspannung (Uo) einer bestimmten Polarität des invertierenden Verstärkers (U1) das Produkt der Spannungsverstärkung zwischen dem Eingangsanschluß (A) des Strom-Spannungswandlers und dem Ausgangsanschluß (C) des invertierenden Verstärkers (U1) und der entsprechenden maximalen Spannung am Begrenzungsmittel ist,
dadurch gekennzeichnet, daß
ein zweiter Verstärker (U2) in den Übertragungsweg vom Eingangsanschluß (A) des Strom-Spannungswandlers zum invertierenden Eingangsanschluß des invertierenden Verstärkers (U1) eingefügt ist,
ein dritter Verstärker (U3) vorgesehen ist, dessen Eingangsanschluß mit dem Ausgangsanschluß des zweiten Verstärkers (U2) verbunden ist, und der Ausgangsanschluß des dritten Verstärkers (U3) mit dem anderen Ende des Begrenzungsmittels so verbunden ist, daß das Produkt der Verstärkungsfaktoren des zweiten und dritten Verstärkers ungefähr +1, jedoch nicht größer als + 1 ist, und daß die Ausgangsspannungsspitze des dritten Verstärkers (U3) begrenzt ist, ohne daß der dritte Verstärker in Sättigung tritt.

2. Strom-Spannungswandler nach Anspruch 1, dadurch gekennzeichnet, daß die Verstärkungsfaktoren des zweiten Verstärkers (U2) und des dritten Verstärkers (U3) ungefähr + 1 betragen.

3. Strom-Spannungswandler nach Anspruch 1 oder 2, dadurch gekennzeichnet, daß die Begrenzung der Ausgangsspannungsspitze des dritten Verstärkers (U3) durch ein weiteres Begrenzungsmittel gebildet wird, das zwischen den Ausgangsanschluß des dritten Verstärkers und ein festes Potential angeschlossen ist.

4. Strom-Spannungswandler nach Anspruch 3, dadurch gekennzeichnet, daß der dritte Verstärker (U3) einen Transistor (Q2) enthält, dessen Basis mit dem Ausgang des zweiten Verstärkers (U2) verbunden ist, dessen Emitter an den Verbindungspunkt (D) des Begrenzungsmittels und des weiteren Begrenzungsmittels angeschlossen ist und der über einen Widerstand (R7) an einen von Masse verschiedenen Spannungspegel angeschlossen ist.

5. Strom-Spannungswandler nach einem der Ansprüche 2 bis 4, dadurch gekennzeichnet, daß der zweite Verstärker einen Feldeffekttransistor enthält, dessen Gate-Anschluß mit dem Eingangsanschluß (A) des Strom-Spannungswandlers verbunden ist und dessen Source-Anschluß der Ausgangsanschluß des zweiten Verstärkers ist.

6. Strom-Spannungswandler nach einem der Ansprüche 2 bis 5, dadurch gekennzeichnet, daß der Ausgangsanschluß des zweiten Verstärkers mit einer Konstantstrom-Einrichtung (IQ) verbunden ist.

7. Strom-Spannungswandler nach einem der vorhergehenden Ansprüche, dadurch gekennzeichnet, daß sein Eingangsanschluß (A) an ein photoelektrisches Empfängerelement, vorzugsweise an eine Photodiode (Dph) angeschlossen ist.

## Revendications

1. Convertisseur courant-tension comprenant: une borne d'entrée (A), un moyen à amplificateur comprenant un amplificateur inverseur (U1) ayant une borne d'entrée inverseuse et une borne de sortie, la borne de sortie étant reliée à la borne d'entrée (A) du convertisseur courant-tension via une résistance (RF),
dans lequel une extrémité d'un moyen d'écrêtage de tension est connectée à la borne d'entrée (A) du convertisseur courant-tension, et dans lequel l'amplificateur inverseur (U1) a un gain tel que le maximum de la tension de sortie (Uo) d'une polarité spécifique de l'amplificateur inverseur (U1) est égal au produit du gain de tension entre la borne d'entrée (A) du convertisseur courant-tension et la borne de sortie (C) de l'amplificateur inverseur (U1) par la tension maximum correspondante à travers le moyen d'écrêtage,
caractérisé en ce qu'un second amplificateur (U2) est inséré dans le chemin entre la borne d'entrée (A) du convertisseur courant-tension et la borne d'entrée inverseuse de l'amplificateur inverseur (U1), et
en ce qu'il est prévu un troisième inverseur (U3) dont la borne d'entrée est reliée à la borne de sortie du second amplificateur (U2) et dont la borne de sortie est reliée à l'autre extrémité du moyen d'écrêtage, le produit des gains des second et troisième amplificateurs étant égal approximativement à + 1, mais non supérieur à + 1, et l'excursion de la tension de sortie du troisième amplificateur (U3) étant limitée sans que ne se produise une saturation du troisième amplificateur.

2. Convertisseur courant-tension selon la revendication 1, caractérisé en ce que les gains du second amplificateur (U2) et du troisième amplificateur (U3) sont approximativement égaux à + 1.

3. Convertisseur courant-tension selon la revendication 1 ou 2, caractérisé en ce que la limitation de l'excursion de la tension de sortie du troisième amplificateur (U3) est réalisée par un moyen d'écrêtage supplémentaire connecté entre la borne de sortie du troisième amplificateur et un potentiel fixe.

4. Convertisseur courant-tension selon la revendication 3, caractérisé en ce que le troisième amplificateur (U3) comprend un transistor (Q2) dont la base est reliée à la sortie du second amplificateur (U2), dont l'émetteur est connecté au point de connexion (D) du moyen d'écrêtage et du moyen d'écrêtage supplémentaire et est relié via une résistance (R7) à un niveau de tension différent de celui de la masse.

5. Convertisseur courant-tension selon l'une quelconque des revendications 2 à 4, caractérisé en ce que le second amplificateur comprend un transistor à effet de champ (FET) dont la grille est connectée à la borne d'entrée (A) du convertisseur courant-tension et dont la source constitue la borne de sortie du second amplificateur.

6. Convertisseur courant-tension selon l'une quelconque des revendications 2 à 5, caractérisé en ce que la borne de sortie du second amplificateur est connectée à un dispositif à courant constant (IQ).

7. Convertisseur courant-tension selon l'une quelconque des revendications précédentes, caractérisé en ce que sa borne d'entrée (A) est connectée à un élément de réception photoélectrique, de préférence une photodiode (Dph).
